# EUROPEAN PATENT APPLICATION

(11) **EP 4 358 133 A1**
(43) Date of publication of application: **24.04.2024**
(21) Application number: 21952447.7
(22) Date of filing: 06.08.2021
(51) Int. Cl.: H01L 23/498, H01L 23/31, H01L 21/56, H01L 23/538, H01L 25/10, H01L 25/18, H01L 21/48

(54) **CHIP PACKAGING STRUCTURE, AND PACKAGING METHOD THEREFOR AND ELECTRONIC DEVICE THEREWITH**

(71) Applicant: Huawei Technologies Co., Ltd., Shenzhen, Guangdong 518129 (CN)
(72) Inventor: CHIANG, Shanghsuan, Shenzhen, Guangdong 518129 (CN)
(74) Representative: Maiwald GmbH
(86) International application number: PCT/CN2021/111334
(87) International publication number: WO 2023/010574

(57) **Abstract**

Embodiments of this application relate to the field of semiconductor technologies, and provide a chip package structure and a packaging method thereof, and an electronic device, to improve low board level reliability of the chip package structure. The chip package structure includes: a substrate; a first connection chip, disposed on a first surface of the substrate, where an active surface of the first connection chip is away from the substrate; a plurality of conductive columns, disposed on the first surface of the substrate and located on a periphery of the first connection chip, where the conductive columns are directly coupled to the substrate; a first packaging layer, disposed on the first surface of the substrate and wrapping a side surface of the first connection chip and side surfaces of the conductive columns, with the active surface of the first connection chip and top surfaces of the conductive columns exposed; a first chip, disposed on a side that is of the first packaging layer and that is away from the substrate, and coupled to both the conductive columns and the first connection chip; and a second chip, disposed on the side that is of the first packaging layer and that is away from the substrate, and coupled to both the conductive columns and the first connection chip.

## Description

### TECHNICAL FIELD

This application relates to the field of semiconductor technologies, and in particular, to a chip package structure and a packaging method thereof, and an electronic device.

### BACKGROUND

With the development of electronic technologies, electronic devices tend to have diversified and all-inclusive functions, which boosts the demand for chip evolution and iteration to a higher level and spurs the integration level of chips. Multi-chip integration, high-density integration, and multi-die packaging are becoming a trend. However, an increasing quantity of stacked chips scales up the chip package structure, and an over-sized chip package structure faces great challenges in stress and process.

A coefficient of thermal expansion (coefficient of thermal expansion, CTE) varies greatly with different structures in packaging and bonding processes. Thermal expansion at a high temperature and cooling at a low temperature generate a large interaction force (stress) between the structures, which causes problems of warpage (warpage), die corner cracking (die corner cracking), bump cracking (bump cracking), and the like to the chip package structure. In addition, if the chip package structure is over-sized, an underfill may be insufficiently applied in an underfill (underfill) process and a die may be insufficiently attached in a die bonding (die bonding) process. As a result, board level reliability (board level reliability, BLR) of the chip package structure is compromised.

### SUMMARY

Embodiments of this application provide a chip package structure and a packaging method thereof, and an electronic device, to address low board level reliability of the chip package structure.

To achieve the foregoing objective, this application uses the following technical solutions.

According to a first aspect of embodiments of this application, a packaging method for a chip package structure is provided, including: forming a plurality of conductive columns on a first surface of a substrate, where the conductive columns are located on a periphery of a to-be-disposed first connection chip area, and are directly coupled to the substrate; disposing a first connection chip on the first surface of the substrate, where an active surface of the first connection chip is away from the substrate; forming a first packaging layer on the first surface of the substrate, where the first packaging layer wraps a side surface of the first connection chip and side surfaces of the conductive columns, with the active surface of the first connection chip and top surfaces of the conductive columns exposed; coupling a first chip to the conductive columns and the first connection chip; and coupling a second chip to the conductive columns and the first connection chip.

In embodiments of this application, in a packaging process, the conductive columns are directly grown on the first surface of the substrate, so that the conductive columns are directly coupled to a first substrate. This obviates the need to transfer and bond the conductive columns onto the substrate, making process steps simple. In addition, the conductive columns and the substrate do not need to be bonded by using a solder, thereby avoiding a signal conduction problem caused by poor bonding. The absence of a bonding interface between the conductive columns and the substrate ensures a better signal conduction effect and a more stable structure. In addition, in embodiments of this application, the packaged first chip and the packaged second chip are separately coupled to the conductive columns and the first connection chip by using a process such as TCB or MR, instead of being packaged together in advance. The first chip and the second chip are interconnected through the first connection chip to implement packaging, and the packaging is similar to multi-chip module packaging in appearance. Therefore, compared with bonding between a large-area multi-die packaging structure and the substrate, bonding between a single chip and the substrate can reduce process difficulty, improve process implementability, and avoid problems of invalid bonding and incomplete underfilling (an underfill is insufficiently applied), thereby improving a product yield rate. In addition, compared with bonding of the large-area multi-die packaging structure, bonding of the single chip can significantly reduce stress and alleviate problems of stress, warpage, and the like caused by a large size of the chip package structure.

In some embodiments, before the coupling a first chip to the conductive columns and the first connection chip, the packaging method further includes: forming a redistribution layer on the first packaging layer, where the redistribution layer is coupled to the conductive columns and the first connection chip. When the redistribution layer is disposed between the conductive columns and the first chip and between the conductive columns and the second chip, signal pins on the substrate may be re-arranged by the redistribution layer, and line precision and signal density may be improved, thereby implementing high-density interconnection.

In some embodiments, the disposing a first connection chip on the first surface of the substrate includes: bonding a back surface of the first connection chip to the substrate. This process is simple and easy to implement.

In some embodiments, the first connection chip includes vias that penetrate a back surface of the first connection chip, and the disposing a first connection chip on the first surface of the substrate includes: coupling the back surface of the first connection chip to the substrate. When the first connection chip is selected as a chip including the vias, and the vias are coupled to the substrate, power supply and a signal transmission amount may be increased, and utilization of pins below the first connection chip may be improved.

In some embodiments, the forming a plurality of conductive columns on a first surface of a substrate includes: forming the plurality of conductive columns on the first surface of the substrate by using an electroplating process or a through molding via technology. This process is simple and easy to implement.

According to a second aspect of embodiments of this application, a chip package structure is provided, including: a substrate; a first connection chip, disposed on a first surface of the substrate, where an active surface of the first connection chip is away from the substrate; a plurality of conductive columns, disposed on the first surface of the substrate and located on a periphery of the first connection chip, where the conductive columns are directly coupled to the substrate; a first packaging layer, disposed on the first surface of the substrate and wrapping a side surface of the first connection chip and side surfaces of the conductive columns, with the active surface of the first connection chip and top surfaces of the conductive columns exposed; a first chip, disposed on a side that is of the first packaging layer and that is away from the substrate, and coupled to both the conductive columns and the first connection chip; and a second chip, disposed on the side that is of the first packaging layer and that is away from the substrate, and coupled to both the conductive columns and the first connection chip.

In embodiments of this application, according to the packaging method provided in the first aspect, in a process of packaging the chip package structure, the conductive columns are directly grown on the first surface of the substrate, so that the conductive columns are directly coupled to a first substrate. This obviates the need to transfer and bond the conductive columns onto the substrate, making process steps simple. In addition, the conductive columns and the substrate do not need to be bonded by using a solder, thereby avoiding a signal conduction problem caused by poor bonding. The absence of a bonding interface between the conductive columns and the substrate ensures a better signal conduction effect and a more stable structure. In addition, the first connection chip is a chip. Compared with a manner in which cabling is performed on a substrate, integration of the first connection chip and a second connection chip is higher. This means an obtained chip package structure is more highly integrated, and is therefore applicable to an ultra-high-density and high-performance computing package. In addition, in embodiments of this application, the packaged first chip and the packaged second chip are separately coupled to the conductive columns and the first connection chip by using a process such as TCB or MR, instead of being packaged together in advance. The first chip and the second chip are interconnected through the first connection chip to implement packaging, and the packaging is similar to multi-chip module packaging in appearance. Therefore, compared with bonding between a large-area multi-die packaging structure and the substrate, bonding between a single chip and the substrate can reduce process difficulty, improve process implementability, and avoid problems of invalid bonding and incomplete underfilling (an underfill is insufficiently applied), thereby improving a product yield rate. In addition, compared with bonding of the large-area multi-die packaging structure, bonding of the single chip can significantly reduce stress and alleviate problems of stress, warpage, and the like caused by a large size of the chip package structure. In addition, in embodiments of this application, the first chip and the second chip are separately disposed on the substrate, and may be applicable to heterogeneous integration of chiplets (chiplets) in the future. A large chip is split into single dies, to implement multi-die packaging and thereby form a system in package.

In some embodiments, the chip package structure further includes a redistribution layer. The redistribution layer is disposed between the first packaging layer and the first chip, and is coupled to the conductive columns and the first connection chip. The redistribution layer is further coupled to the first chip and the second chip. When the redistribution layer is disposed between the conductive columns and the first chip and between the conductive columns and the second chip, signal pins on the substrate may be re-arranged by the redistribution layer, and line precision and signal density may be improved, thereby implementing high-density interconnection.

In some embodiments, a back surface of the first connection chip adheres to the substrate. The structure is simple and easy to implement.

In some embodiments, the first connection chip includes vias, where the vias penetrate a back surface of the first connection chip and are coupled to the substrate. When the first connection chip is selected as a chip including the vias, and the vias are coupled to the substrate, power supply and a signal transmission amount may be increased, and utilization of pins below the first connection chip may be improved.

In some embodiments, the chip package structure further includes a ring. The ring is disposed on the first surface of the substrate and is located on a periphery of the first packaging layer. The ring may enhance mechanical strength of the chip package structure and prevent warpage of the substrate, thereby improving package reliability.

In some embodiments, heights of the plurality of conductive columns are the same in a direction perpendicular to the substrate. In this way, the plurality of conductive columns may be formed at a time by using a same process, and the process is simple and low-cost.

In some embodiments, the chip package structure further includes a second packaging layer. The second packaging layer is disposed on the first packaging layer and wraps at least a side surface of the first chip and a side surface of the second chip. The second packaging layer may help stabilize the first chip and the second chip.

In some embodiments, the chip package structure further includes a ring. The ring is disposed on the first packaging layer and surrounds the first chip and the second chip. The ring may enhance mechanical strength of the chip package structure and prevent warpage of the substrate, thereby improving package reliability.

In some embodiments, the chip package structure further includes a heat dissipating lid. The heat dissipating lid has a groove, and is butted with the substrate. The groove and the substrate form an accommodation cavity. The first packaging layer, the first chip, and the second chip are located in the accommodation cavity. The heat dissipating lid may protect the first chip and the second chip, and may further improve heat dissipation effects of the first chip and the second chip.

In some embodiments, the chip package structure further includes a third packaging layer. The third packaging layer is disposed on the first surface of the substrate and wraps at least the side surface of the first chip, the side surface of the second chip, and the first packaging layer. The third packaging layer may enhance mechanical strength of the chip package structure and prevent warpage of the substrate, thereby improving package reliability.

In some embodiments, the chip package structure further includes a second connection chip and a third chip. The second connection chip is disposed on the first surface of the substrate, and an active surface of the second connection chip is away from the substrate. The third chip is disposed on the side that is of the first packaging layer and that is away from the substrate, and coupled to both the conductive columns and the second connection chip. The second chip is further coupled to the second connection chip. The structure is flexible and widely applicable, and therefore can meet different requirements.

In some embodiments, the chip package structure further includes a fourth chip. The fourth chip is disposed on a second surface of the substrate, and is coupled to the substrate. The first surface of the substrate is disposed opposite to the second surface. The structure is flexible and widely applicable, and therefore can meet different requirements.

According to a third aspect of embodiments of this application, an electronic device is provided, including the chip package structure according to any embodiment in the first aspect. The electronic device further includes a printed circuit board, where the chip package structure is disposed on the printed circuit board, and the chip package structure is coupled to the printed circuit board through a substrate.

The electronic device provided in the third aspect of embodiments of this application includes the chip package structure according to any embodiment in the first aspect. Beneficial effects of the electronic device are the same as beneficial effects of the chip package structure. Details are not described herein again.

### BRIEF DESCRIPTION OF DRAWINGS

FIG. 1 is a schematic diagram of a structure of an electronic device according to an embodiment of this application;
FIG. 2A is a schematic diagram of a structure of a chip package structure according to an embodiment of this application;
FIG. 2B is a schematic diagram of a structure of another chip package structure according to an embodiment of this application;
FIG. 3 is a schematic diagram of a structure of still another chip package structure according to an embodiment of this application;
FIG. 4 is a schematic flowchart of a packaging method for a chip package structure according to an embodiment of this application;
FIG. 5A to FIG. 5P are schematic diagrams of a chip package structure packaging process according to an embodiment of this application;
FIG. 6A is a schematic diagram of a structure of still another chip package structure according to an embodiment of this application;
FIG. 6B is a schematic diagram of a structure of still another chip package structure according to an embodiment of this application;
FIG. 6C is a schematic diagram of a structure of still another chip package structure according to an embodiment of this application;
FIG. 6D is a schematic diagram of a structure of still another chip package structure according to an embodiment of this application;
FIG. 7A is a schematic diagram of a structure of still another chip package structure according to an embodiment of this application;
FIG. 7B is a schematic flowchart of another packaging method for a chip package structure according to an embodiment of this application;
FIG. 8A is a schematic diagram of a structure of still another chip package structure according to an embodiment of this application;
FIG. 8B is a schematic diagram of a structure of still another chip package structure according to an embodiment of this application;
FIG. 9A is a schematic diagram of a structure of still another chip package structure according to an embodiment of this application;
FIG. 9B is a schematic flowchart of still another packaging method for a chip package structure according to an embodiment of this application;
FIG. 10A is a schematic diagram of a structure of still another chip package structure according to an embodiment of this application;
FIG. 10B is a schematic diagram of a structure of still another chip package structure according to an embodiment of this application;
FIG. 10C is a schematic diagram of a structure of still another chip package structure according to an embodiment of this application;
FIG. 10D is a top view of a multi-chip interconnection manner according to an embodiment of this application;
FIG. 10E is a top view of another multi-chip interconnection manner according to an embodiment of this application;
FIG. 11A is a schematic diagram of a structure of still another chip package structure according to an embodiment of this application;
FIG. 11B is a schematic flowchart of still another packaging method for a chip package structure according to an embodiment of this application;
FIG. 12A is a schematic diagram of a structure of still another chip package structure according to an embodiment of this application;
FIG. 12B is a schematic diagram of a structure of still another chip package structure according to an embodiment of this application;
FIG. 13A is a schematic diagram of a structure of still another chip package structure according to an embodiment of this application;
FIG. 13B is a schematic diagram of a structure of still another chip package structure according to an embodiment of this application;
FIG. 13C is a schematic diagram of a structure of still another chip package structure according to an embodiment of this application;
FIG. 13D is a schematic diagram of a structure of still another chip package structure according to an embodiment of this application; and
FIG. 13E is a schematic diagram of a structure of still another chip package structure according to an embodiment of this application.

### Reference numerals:

1: Electronic device; 2: Display module; 3: Middle frame; 4: Housing; 5: Cover. 11: First chip; 12: Second chip; 13: First connection chip; 131: Via; 14: Conductive column; 15: First packaging layer; 16: Redistribution layer; 17: Underfill layer; 18: Ring; 18': Second packaging layer; 19: Heat dissipating lid; 19': Third packaging layer; 20: Fourth chip; 21: Third chip; 22: Second connection chip.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In embodiments of this application, the terms "first", "second", and the like mentioned below are merely intended for ease of description, and shall not be understood as an indication or implication of relative importance or implicit indication of the number of indicated technical features. Therefore, a feature limited by "first", "second", or the like may explicitly or implicitly include one or more features. In the descriptions of this application, unless otherwise stated, "a plurality of" means two or more than two.

In embodiments of this application, "up", "down", "left", and "right" are not limited to definitions relative to directions in which components are schematically placed in the accompanying drawings. It should be understood that these directional terms may be relative concepts used for relative description and clarification, and may change correspondingly according to a change of a direction in which a component in the accompanying drawings is placed.

In embodiments of this application, unless otherwise specified in the context, in the entire specification and claims, the term "include" is interpreted as "open and inclusive", that is, "include, but not limited to". In the description of the specification, terms such as "an embodiment", "some embodiments", "example embodiments", "for example", or "some examples" are intended to indicate that a specific feature, structure, material, or characteristic related to the embodiment or example is included in at least one embodiment or example of the present disclosure. The foregoing schematic representations of the terms do not necessarily refer to a same embodiment or example. Further, the specific feature, structure, material, or characteristic may be included in any one or more embodiments or examples in any appropriate manner.

When some embodiments are described, expressions such as "couple" and "connect" and derivatives thereof may be used. For example, when some embodiments are described, the term "connect" may be used to indicate that two or more components are in direct physical contact or electrical contact with each other. For another example, when some embodiments are described, the term "couple" may be used to indicate that two or more components are in direct physical contact or electrical contact. However, the term "couple" may also mean that two or more components are not in direct contact with each other, but collaborate or interact with each other. The embodiments disclosed herein are not necessarily limited to the content of this specification.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In embodiments of this application, an example implementation is described with reference to a cutaway view and/or a plane diagram and/or an equivalent circuit diagram that are/is used as an idealized example accompanying drawing. In the accompanying drawings, for clarity, thicknesses of layers and areas are enlarged. Therefore, a change in the shape of the drawings due to, for example, manufacturing techniques and/or tolerances may be envisaged. Therefore, the example implementation should not be construed as being limited to the shape of the area shown herein, but rather include a shape deviation caused by, for example, a manufacturing factor. For example, an etched area shown as a rectangle typically has a bending characteristic. Therefore, an area shown in the accompanying drawings is essentially schematic, and the shape of the area is neither intended to show an actual shape of a corresponding area on a device, nor intended to limit the scope of the example implementation.

Embodiments of this application provide an electronic device. The electronic device may be a terminal device having a display interface, such as a mobile phone, a television, a display, a tablet, or a vehicle-mounted computer, or may be an intelligent display wearable device such as a smartwatch or a smart band, or may be a communication device such as a server, a memory, or a base station, or may be a smart automobile, or the like. A specific form of the electronic device is not specifically limited in embodiments of this application. For ease of description, the following embodiments are described by using an example in which the electronic device is a mobile phone.

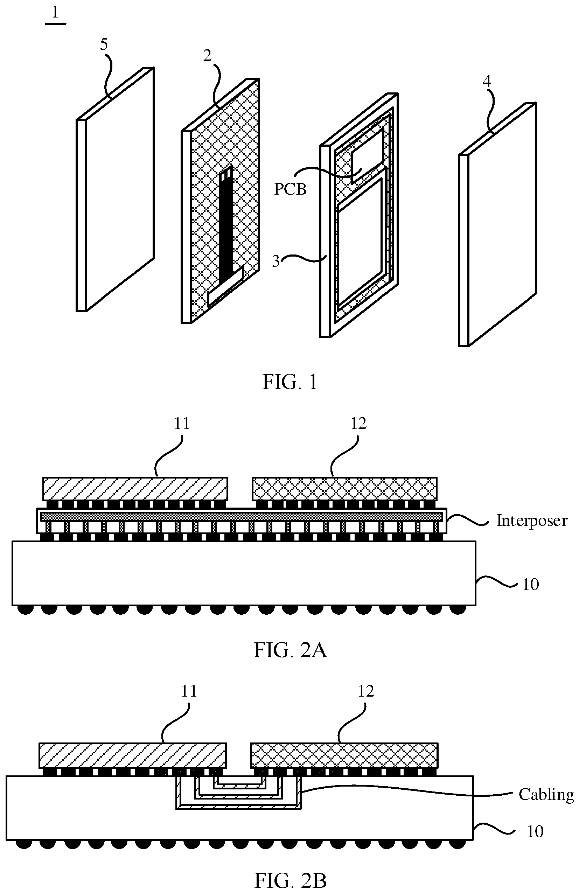

In this case, as shown in FIG. 1, an electronic device 1 mainly includes a display module 2, a middle frame 3, a housing (or referred to as a battery cover or a backshell) 4, and a cover 5.

The display module 2 has a light exit side on which a displayed image can be seen, and a back surface opposite to the light exit side. The back surface of the display module 2 is close to the middle frame 3. The cover 5 is disposed on the light exit side of the display module 2.

The display module 2 includes a display panel (display panel, DP).

In a possible embodiment of this application, the display module 2 is a liquid crystal display module. In this case, the display panel is a liquid crystal display (liquid crystal display, LCD). In view of this, the display module 2 further includes a backlight unit (backlight unit, BLU) located on a back surface (on the opposite side of the LCD that is used to display an image) of the liquid crystal display.

The backlight unit may provide a light source for the liquid crystal display, so that each sub-pixel (sub-pixel) in the liquid crystal display can emit light to display an image.

Alternatively, in another possible embodiment of this application, the display module 2 is an organic light emitting diode display module. In this case, the display panel is an organic light emitting diode (organic light emitting diode, OLED) display panel. Because an electroluminescent layer is disposed in each sub-pixel of the OLED display panel, the OLED display panel can implement self-illumination after receiving an operating voltage. In this case, the backlight unit no longer needs to be disposed in the display module 2 with the OLED display panel.

The cover 5 is located on a side that is of the display module 2 and that is away from the middle frame 3. For example, the cover 5 may be cover glass (cover glass, CG), and the cover glass may have some toughness.

The middle frame 3 is located between the display module 2 and the housing 4. Internal components, for example, a battery, a printed circuit board (printed circuit board, PCB), a camera (camera), and an antenna may be installed on a surface that is of the middle frame 3 and that is away from the display module 2. After the housing 4 and the middle frame 3 are bonded together, the internal components are located between the housing 4 and the middle frame 3.

The electronic device 1 further includes electronic components such as a processor chip (CPU), a radio frequency chip, a radio frequency power amplifier (power amplifier, PA) chip, a system on a chip (system on a chip, SOC), a power management integrated circuit (power management integrated circuit, PMIC), a memory chip (for example, a high bandwidth memory (high bandwidth memory, HBM)), an audio processor chip, a touchscreen control chip, a NAND flash (flash memory), and an image sensor chip that are disposed on the PCB. The PCB is configured to support the electronic components, and complete signal interaction with the electronic components.

With the development of electronic technologies, the electronic device 1 tends to have diversified and all-inclusive functions, which boosts the demand for chip evolution and iteration to a higher level and spurs the integration level of chips in the electronic device 1. Multi-chip integration, high-density integration, and multi-die packaging are becoming a trend.

Therefore, to improve the integration level of the chip in the electronic device 1, in some embodiments, as shown in FIG. 2A, a chip package structure is provided, including a substrate (substrate) 10, a first chip 11, a second chip 12, and an interposer. The interposer is disposed on the substrate 10, and the first chip 11 and the second chip 12 are disposed on a side that is of the interposer and that is away from the substrate 10. The first chip 11 and the second chip 12 are bonded to the interposer, and the interposer is bonded to the substrate 10, so that the first chip 11 and the second chip 12 are coupled to the substrate 10.

In this chip package structure, the first chip 11 and the second chip 12 are integrated and packaged, and then the substrate 10 is bonded to the PCB, so that an integration level of chips on the PCB can be improved.

However, in this chip package structure, when the interposer is bonded to the substrate 10, problems of stress (stress), warpage (warpage), and the like may occur due to a large area of the interposer.

Therefore, to address the stress and warpage problems in the chip package structure, in some embodiments, as shown in FIG. 2B, another chip package structure is provided, including a substrate 10, a first chip 11, and a second chip 12. The first chip 11 and the second chip 12 are interconnected by using cabling on the substrate 10, to complete signal interworking.

In this chip package structure, the first chip 11 and the second chip 12 are separately coupled to the substrate, thereby alleviating the foregoing problems of stress (stress), warpage (warpage), and the like that occur during bonding due to an excessively large area of the interposer.

However, in this chip package structure, due to a process limitation and a large linewidth and a large line spacing of cabling on the substrate 10, integration of the chip package structure cannot be further improved, and therefore comes to a grinding halt.

Therefore, to address the problems of low integration, stress (stress), warpage (warpage), and the like of the foregoing chip package structure, an embodiment of this application further provides a chip package structure. The chip package structure may be applied to any one of the foregoing electronic devices.

The following describes the chip package structure provided in this embodiment of this application by using several examples.

### Example 1

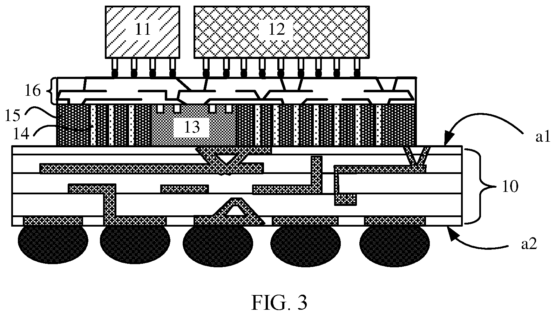

A chip package structure is provided. As shown in FIG. 3, the chip package structure mainly includes a substrate 10, a first chip 11, a second chip 12, a first connection chip 13, a plurality of conductive columns 14, a first packaging layer 15, and a redistribution layer 16.

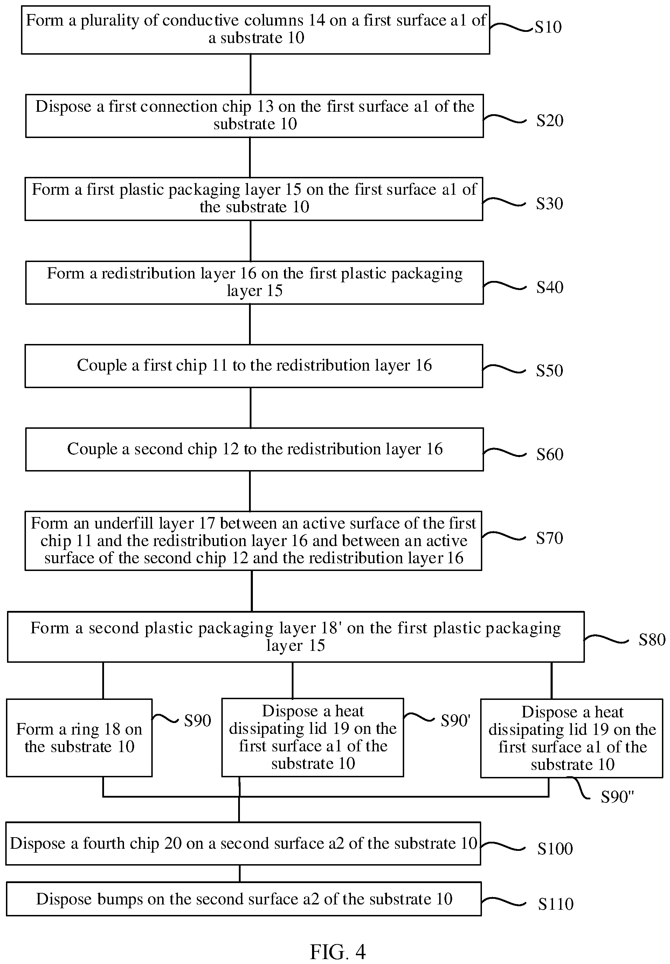

As shown in FIG. 4, this embodiment of this application provides a packaging method for a chip package structure, including the following steps.

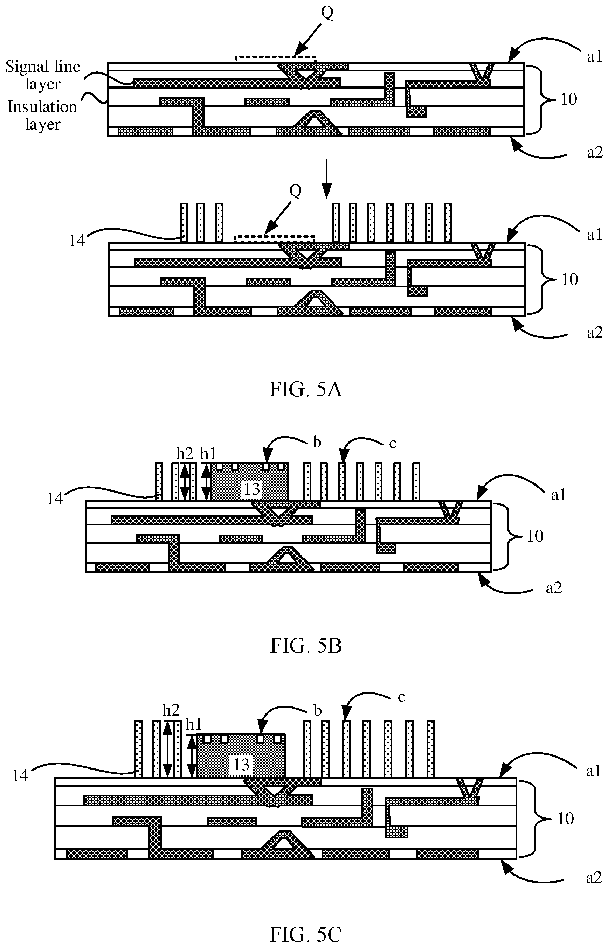

S10: As shown in FIG. 5A, form the plurality of conductive columns 14 on a first surface a1 of the substrate 10.

As shown in FIG. 5A, the substrate 10 has the first surface a1 and a second surface a2 that are opposite to each other. A structure of the substrate 10 is not limited in this embodiment of this application, as long as the substrate 10 can implement transmission of a signal from the first surface a1 to the second surface a2.

For example, the substrate 10 includes a plurality of signal line layers, an insulation layer is disposed between adjacent signal line layers, and the adjacent signal line layers are coupled through vias on the insulation layer. In this way, signal transmission is implemented.

A to-be-disposed first connection chip area Q is reserved on the first surface a1 of the substrate 10 for subsequent disposition of the first connection chip 13.

It should be understood that a quantity of to-be-disposed first connection chip areas Q is reserved based on a quantity of first connection chips 13 that need to be disposed. FIG. 5A is merely an example in which one first connection chip 13 is disposed on the substrate 10. When a plurality of first connection chips 13 need to be disposed on the substrate 10, the conductive columns 14 are located on a periphery of each of a plurality of to-be-disposed first connection chip areas Q. That is, no conductive columns 14 are disposed in each to-be-disposed first connection chip area Q.

As shown in FIG. 5A, in this embodiment of this application, when the chip package structure is formed, the conductive columns 14 are directly formed on the substrate 10 without a process such as bearing by a carrier board and transferring and bonding. The formed conductive columns 14 are located on the periphery of the to-be-disposed first connection chip area Q.

In this embodiment of this application, a material of the conductive columns 14 is not limited, and a method for forming the conductive columns 14 on the substrate 10 is not limited either, as long as the conductive columns 14 can be directly coupled to the substrate 10.

The conductive columns 14 are directly coupled to the substrate 10, that is, there is no solder between the conductive columns 14 and the first surface a1 of the substrate 10. After the conductive columns 14 are formed on the substrate 10, the conductive columns 14 are directly coupled to the substrate 10, obviating a process such as a bump process.

For a manner in which the conductive columns 14 are formed, in some embodiments, the plurality of conductive columns 14 are formed on the first surface a1 of the substrate 10 by using an electroplating process.

For example, a patterned mask layer may be first formed on the first surface a1 of the substrate 10, vias are disposed in the mask layer, then a conductive column 14 is formed in each via, and finally the mask layer is removed.

In some other embodiments, the plurality of conductive columns 14 are formed on the first surface a1 of the substrate 10 by using a through molding via (through molding via, TMV) technology.

As shown in FIG. 5A, the plurality of conductive columns 14 that are formed are disposed on the first surface a1 of the substrate 10. In this embodiment of this application, the material of the conductive columns 14 may include one or more of titanium (Ti), copper (Cu), nickel (Ni), cobalt (Co), tungsten (W), or a related alloy.

In some embodiments, heights of the plurality of conductive columns 14 are the same in a direction perpendicular to the substrate 10.

In this way, the plurality of conductive columns 14 may be formed at a time by using a same process. This obviates the need to form conductive columns of different heights in batches, and the process is simple and low-cost.

S20: As shown in FIG. 5B, dispose the first connection chip 13 on the first surface a1 of the substrate 10.

It may be understood that, when the first connection chip 13 is disposed on the substrate 10, the first connection chip 13 is located at the reserved to-be-disposed first connection chip area Q on the first surface a1 of the substrate 10.

The first connection chip 13 may be obtained by, for example, cutting a line that is directly made on a wafer based on a requirement, and applied to the chip package structure. For example, the first connection chip 13 may be understood as a silicon bridge die (silicon bridge die, SBD). Certainly, a substrate material of the first connection chip 13 may include one or more of silicon (Si), germanium (Ge), gallium nitride (GaN), gallium arsenide (GaAs), or another semiconductor material. Alternatively, the substrate material may be, for example, glass (glass) or an organic material. The silicon bridge die is merely an example.

The quantity of first connection chips 13 is not limited in this embodiment of this application, as long as the quantity is reasonably set as required. FIG. 5B uses only one first connection chip 13 as an example for description.

In some embodiments, the first connection chip 13 is disposed on the first surface a1 of the substrate 10, a back surface of the first connection chip 13 faces the substrate 10, an active surface b of the first connection chip 13 is away from the substrate 10, and the back surface of the first connection chip 13 is fixedly connected to the substrate 10.

For a manner in which the back surface of the first connection chip 13 is fixedly connected to the substrate 10, in some embodiments, the back surface of the first connection chip 13 adheres to the substrate 10.

For example, the back surface of the first connection chip 13 adheres to the substrate 10 by using a die attach film (die attach film, DAF).

Alternatively, for example, the back surface of the first connection chip 13 adheres to the substrate 10 by using a double-sided tape.

It should be noted that whether the active surface b of the first connection chip 13 and top surfaces c (surfaces that are of the conductive columns 14 and that are away from the substrate 10) of the conductive columns 14 are on a same plane may be limited based on a requirement by limiting a height of the conductive columns 14 formed in step S10. Alternatively, the first connection chip 13 may be thinned, to limit whether the active surface b of the first connection chip 13 and top surfaces c (surfaces that are of the conductive columns 14 and that are away from the substrate 10) of the conductive columns 14 are on a same plane.

In some embodiments, as shown in FIG. 5B, the active surface b of the first connection chip 13 and the top surfaces c of the conductive columns 14 are on the same plane.

That is, a height h1 of the first connection chip 13 is equal to a height h2 of the conductive columns 14.

In this way, in a subsequent process of preparing the first packaging layer 15, the step of equalizing the height of the first connection chip 13 and the height of the conductive columns 14 may be omitted.

In some other embodiments, as shown in FIG. 5C, the active surface b of the first connection chip 13 and the top surfaces c of the conductive columns 14 are not on the same plane.

That is, a height h1 of the first connection chip 13 is greater than or less than a height h2 of the conductive columns 14.

This may help lower a requirement on process precision of forming the conductive columns 14, thereby reducing process difficulty.

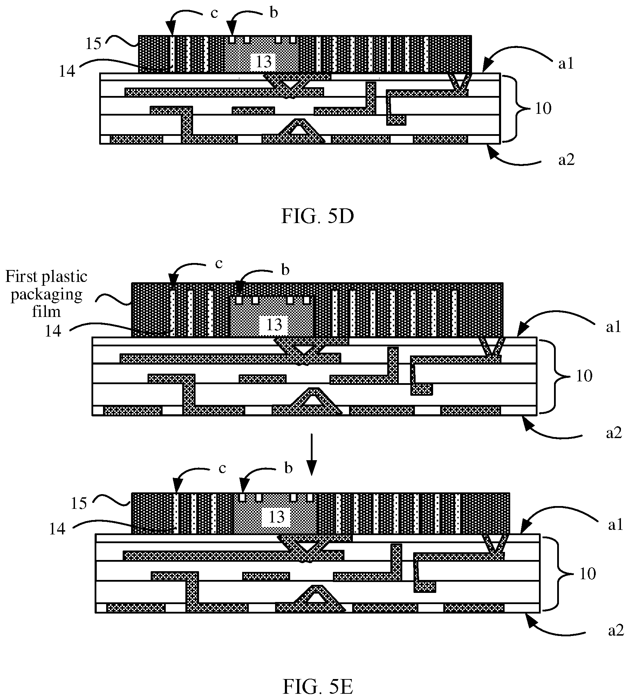

S30: As shown in FIG. 5D, form the first packaging layer 15 on the first surface a1 of the substrate 10.

A structure of the first packaging layer 15 is not limited in this embodiment of this application. The formed first packaging layer 15 is disposed on the first surface a1 of the substrate 10, and a size of the first packaging layer 15 is reasonably set based on a layout of the conductive columns 14 and a layout of the first connection chip 13, so that the first packaging layer 15 wraps a side surface of the first connection chip 13 and side surfaces of the conductive columns 14, with the active surface b of the first connection chip 13 and the top surfaces c of the conductive columns 14 exposed, and the first connection chip 13 and the conductive columns 14 are protected. In some embodiments, as shown in FIG. 5D, the first packaging layer 15 wraps the side surface of the first connection chip 13 and the side surfaces of the conductive columns 14, and the first packaging layer 15 does not completely cover the first surface a1 of the substrate 10.

Because the first packaging layer 15 and the substrate 10 have a large difference in a coefficient of thermal expansion (coefficient of thermal expansion, CTE), a contact area between the first packaging layer 15 and the substrate 10 is reduced as much as possible on the basis that the first packaging layer 15 wraps the side surface of the first connection chip 13 and the side surfaces of the conductive columns 14, to protect the first connection chip 13 and the conductive columns 14. This can reduce cumulative stress caused by the difference in the CTE between the first packaging layer 15 and the substrate 10. In this way, problems of warpage (warpage), die corner cracking (die corner cracking), and the like caused to the chip package structure are alleviated, thereby improving board level reliability of the chip package structure. In addition, a coverage area of the first packaging layer 15 on the substrate 10 is small. This helps alleviate a problem of low heat dissipation efficiency caused by coverage of the first packaging layer 15 on the substrate 10.

In some other embodiments, the first packaging layer 15 wraps the side surface of the first connection chip 13 and the side surfaces of the conductive columns 14, and the first packaging layer 15 covers the first surface a1 of the substrate 10.

For a method for forming the first packaging layer 15, in some embodiments, as shown in FIG. 5D, the first packaging layer 15 is directly formed on the substrate 10, with the active surface b of the first connection chip 13 and the top surfaces c of the conductive columns 14 exposed.

This manner of directly forming the first packaging layer 15 has fewer process steps but higher preparation efficiency.

In some other embodiments, as shown in FIG. 5E, a first packaging film may be first formed on the first surface a1 of the substrate 10, where the first packaging film wraps the conductive columns 14 and the first connection chip 13; and then grinding (grinding) is performed on a surface that is of the first packaging film and that is away from the substrate 10, so that the active surface b of the first connection chip 13 and the top surfaces c of the conductive columns 14 emerge from the first packaging layer 15.

In a case in which the height h1 of the first connection chip 13 is equal to the height h2 of the conductive columns 14, in a process of grinding the surface that is of the first packaging film and that is away from the substrate 10, only the surface that is of the first packaging film and that is away from the substrate 10 may be ground, and the grinding stops when the active surface b of the first connection chip 13 and the top surfaces c of the conductive columns 14 are exposed.

In the process of grinding the surface that is of the first packaging film and that is away from the substrate 10, grinding may further be performed on the active surface b of the first connection chip 13 and the top surfaces c of the conductive columns 14 when the active surface b of the first connection chip 13 and the top surfaces c of the conductive columns 14 are exposed after the surface that is of the first packaging film and that is away from the substrate 10 is ground. In this way, an oxide layer that is located on the active surface b of the first connection chip 13 and the top surfaces c of the conductive columns 14 may be removed, thereby improving a coupling effect.

In a case in which the height h1 of the first connection chip 13 is less than the height h2 of the conductive columns 14, in a process of grinding the surface that is of the first packaging film and that is away from the substrate 10, grinding of the conductive columns 14 and the first packaging film continues when the top surfaces c of the conductive columns 14 are exposed after the surface that is of the first packaging film and that is away from the substrate 10 is ground, and the grinding stops when the active surface b of the first connection chip 13 is exposed.

For a manner of grinding the first packaging film, the first packaging film may be ground by using, for example, a chemical mechanical polishing (chemical mechanical polishing, CMP) process.

This manner of first forming and then grinding the first packaging film to obtain the first packaging layer 15 has a low requirement on process precision, thereby reducing process difficulty. In addition, the height h1 of the first connection chip 13 is not required to be equal to the height h2 of the conductive columns 14.

A material of the first packaging layer 15 may be, for example, a molding (molding), an epoxy molding compound (epoxy molding compound, EMC), or an insulation material.

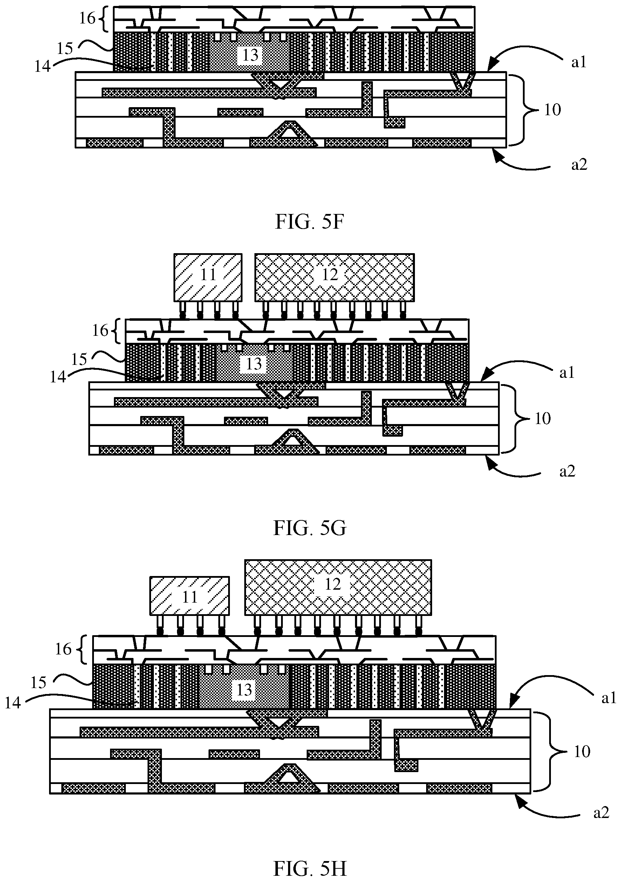

S40: As shown in FIG. 5F, form a redistribution layer (redistribution layer, RDL) 16 on the first packaging layer 15.

The redistribution layer 16 includes at least one layer of a metal wiring structure and an insulation layer used to separate adjacent layers of metal wiring structures, and the adjacent layers of metal wiring structures are electrically connected together by using vias on the insulation layer. A material of the metal wiring structure may include one or more conductive materials of copper, aluminum, nickel, gold, silver, titanium, cobalt, tungsten, and the like. A material of the insulation layer may include one or more of silicon oxide, silicon nitride, silicon oxynitride, silicon carbide, silicon gel, and polyimide.

In this embodiment of this application, the redistribution layer 16 is directly formed on the surface of the first packaging layer 15. In a process of forming the redistribution layer 16, the redistribution layer 16 is directly coupled to the conductive columns 14 and the first connection chip 13. No solder needs to be disposed on both the top surfaces c of the conductive columns 14 and the active surface b of the first connection chip 13.

S50: As shown in FIG. 5G, couple the first chip 11 to the redistribution layer 16.

The redistribution layer 16 is disposed between the first packaging layer 15 and the first chip 11. The first chip 11 is coupled to the redistribution layer 16, and the redistribution layer 16 is coupled to the conductive columns 14 and the first connection chip 13. Therefore, the first chip 11 may be coupled to the conductive columns 14 and the first connection chip 13.

A manner in which the first chip 11 is coupled to the redistribution layer 16 is not limited in this embodiment of this application. For example, the first chip 11 may be coupled to the redistribution layer 16 by using a bonding process. For example, a thermal compression bonding (thermal compression bonding, TCB) process or a mass reflow (mass reflow, MR) process is used for bonding. In other words, the first chip 11 is bonded to the redistribution layer 16. Alternatively, for example, coupling may be performed by using a conductive adhesive. In other words, the first chip 11 adheres to the redistribution layer 16.

S60: As shown in FIG. 5G, couple the second chip 12 to the redistribution layer 16.

The redistribution layer 16 is disposed between the first packaging layer 15 and the second chip 12. The second chip 12 is coupled to the redistribution layer 16, and the redistribution layer 16 is coupled to the conductive columns 14 and the first connection chip 13. Therefore, the second chip 12 may be coupled to the conductive columns 14 and the first connection chip 13.

A manner in which the second chip 12 is coupled to the redistribution layer 16 is not limited in this embodiment of this application. For example, the second chip 12 may be coupled to the redistribution layer 16 by using a bonding process. In other words, the second chip 12 is bonded to the redistribution layer 16. Alternatively, for example, coupling may be performed by using a conductive adhesive. In other words, the second chip 12 adheres to the redistribution layer 16.

It should be noted that, first, there is no limitation on a sequence between step S50 and step S60. Step S50 may precede step S60, or step S60 may precede step S50.

In addition, specific structures of the first chip 11 and the second chip 12 are not limited in this embodiment of this application, and may be any chip required for an electronic device. For example, each chip includes a substrate and a functional layer disposed on the substrate. In a working process, the functional layer may enable the chip to implement a function of the chip, for example, a logical computing function or a storage function. The functional layer mainly includes a functional device, a circuit structure, metal interconnection wires, a dielectric layer, and the like.

In addition, the first chip 11 and the second chip 12 in the chip package structure in this embodiment of this application may be bare chips (or referred to as bare dies, dies, or particles) cut from a wafer, or may be packaged chips obtained by packaging the bare chips. Certainly, there is no limitation on a case in which both the first chip 11 and the second chip 12 need to be the bare chips or a case in which both the first chip 11 and the second chip 12 need to be the packaged chips. For example, the first chip 11 may be a bare chip (for example, the foregoing SOC), and the second chip 12 may be a packaged chip (for example, the foregoing HBM).

In addition, when at least one first chip 11 and at least one second chip 12 in the chip package structure are coupled to the redistribution layer 16, one chip may be coupled to the redistribution layer 16 at a time, or a plurality of chips may be coupled to the redistribution layer 16 at a time.

This is to simplify the structure and facilitate coupling. In some embodiments, as shown in FIG. 5H, an active surface of each first chip 11 and an active surface of each second chip 12 both face the substrate 10.

In addition, as shown in FIG. 5G, thickness of the first chip 11 and the second chip 12 in a direction perpendicular to the substrate 10 may be the same. As shown in FIG. 5H, the thicknesses of the first chip 11 and the second chip 12 in a direction perpendicular to the substrate 10 may alternatively be different. This is not limited in this embodiment of this application.

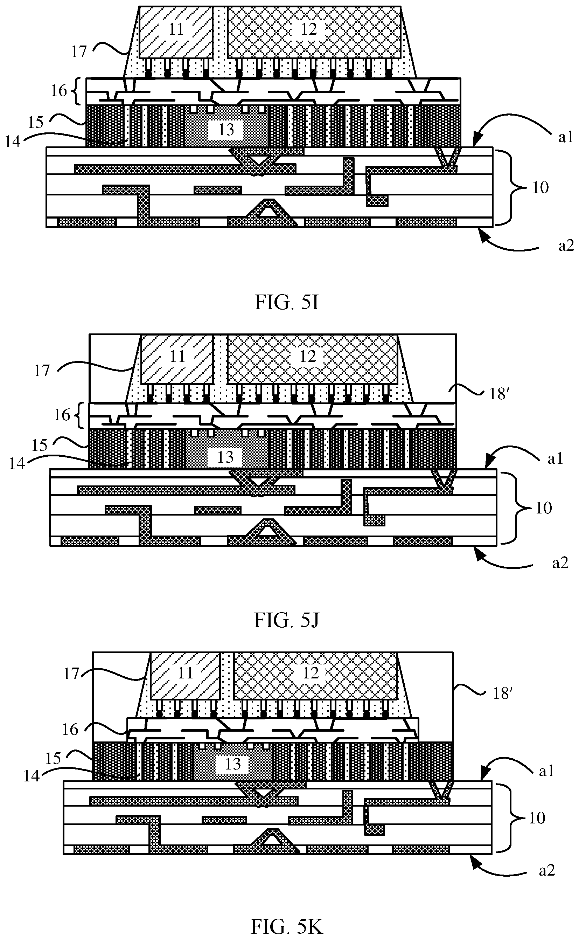

S70: As shown in FIG. 5I, form an underfill layer 17 between the active surface of the first chip 11 and the redistribution layer 16 and between the active surface of the second chip 12 and the redistribution layer 16.

For example, a gap between the active surface of the first chip 11 and the redistribution layer 16 and between the active surface of the second chip 12 and the redistribution layer 16 may be filled with a material such as a capillary underfill (capillary underfill, CUF), a molded underfill (molded underfill, MUF), a non-conductive film (non-conductive film, NCF), or a non-conductive paste (non-conductive paste, NCP), to form the underfill layer 17. The underfill layer 17 protects a coupling position between the first chip 11 and the redistribution layer 16 and between the second chip 12 and the redistribution layer 16, so that a connection between the first chip 11 and the redistribution layer 16 and a connection between the second chip 12 and the redistribution layer 16 are more stable.

In some embodiments, as shown in FIG. 5I, a vertical section of the underfill layer 17 is a trapezoid in a direction from the redistribution layer 16 to the first chip 11 and the second chip 12, and the underfill layer 17 in this structural form is more stable.

In some embodiments, as shown in FIG. 5I, the underfill layer 17 further fills a gap between the first chip 11 and the second chip 12.

In some embodiments, the underfill layer 17 further wraps surfaces that are of the first chip 11 and the second chip 12 and that are away from the substrate 10.

S80: Form a second packaging layer 18' on the first packaging layer 15.

In some embodiments, as shown in FIG. 5J, the second packaging layer 18' is formed on a surface of the redistribution layer 16, and the second packaging layer 18' wraps at least a side surface of the first chip 11 and a side surface of the second chip 12.

In some other embodiments, as shown in FIG. 5K, the second packaging layer 18' is formed on the surface of the first packaging layer 15, and the second packaging layer 18' wraps at least a side surface of the first chip 11, a side surface of the second chip 12, and the redistribution layer 16.

That the second packaging layer 18' wraps at least a side surface of the first chip 11 and a side surface of the second chip 12 may be understood as that the second packaging layer 18' wraps a side surface of the first chip 11 and a side surface of the second chip 12, or that the second packaging layer 18' wraps a side surface and a top surface of the first chip 11 and/or a side surface and a top surface of the second chip 12.

In the following, the second packaging layer 18' wraps at least the side surface of the first chip 11 and the side surface of the second chip 12, that is, the second packaging layer 18' wraps the side surface of the first chip 11 and the side surface of the second chip 12, or the second packaging layer 18' wraps the side surface and the top surface of the first chip 11 and/or the side surface and the top surface of the second chip 12. Details are not described below.

A material of the second packaging layer 18' may be the same as the material of the first packaging layer 15, for example, may be the EMC. The second packaging layer 18' is configured to enhance mechanical strength of the chip package structure and prevent warpage of the substrate 10, to improve package reliability.

S90: Form a ring (ring) 18 on the substrate 10.

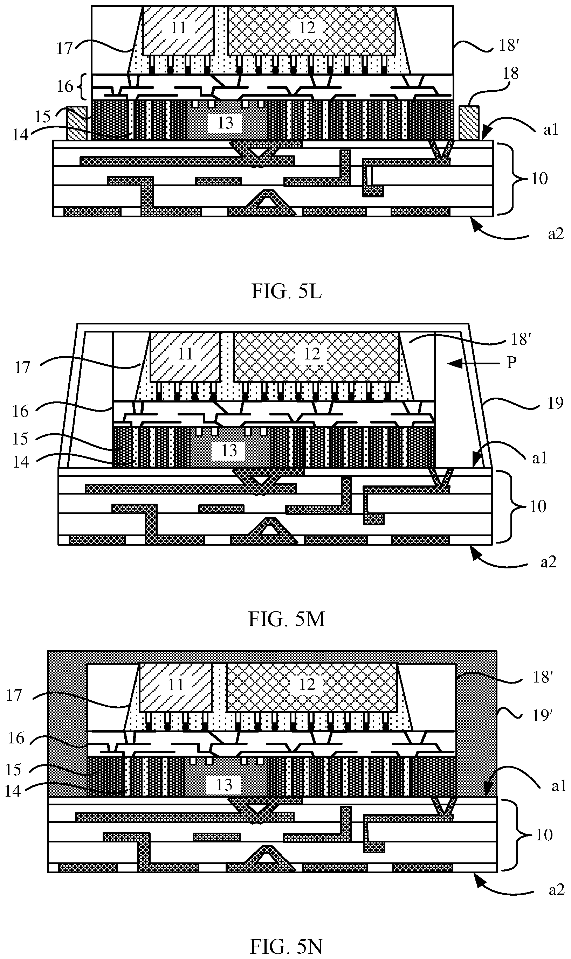

In some embodiments, as shown in FIG. 5L, the ring 18 is formed on the first surface a1 of the substrate 10, the ring 18 is connected to the substrate 10, and the ring 18 surrounds the first packaging layer 15.

In some other embodiments, the ring 18 is formed on the surface of the redistribution layer 16, and the ring 18 surrounds the underfill layer 17 (that is, the first chip 11 and the second chip 12).

In some other embodiments, the ring 18 is formed on the surface of the first packaging layer 15, and the ring 18 surrounds the redistribution layer 16 (that is, the first chip 11 and the second chip 12).

A specific structure of the ring 18 is not limited in this embodiment of this application, and the ring 18 may be a closed circle structure. For example, the ring 18 may be a circular ring or a rectangular ring. A width and a height of the ring 18 are not limited, as long as the width and the height are reasonably set as required.

A material of the ring 18 may be, for example, copper, stainless steel, or alloy. The ring 18 is configured to enhance the mechanical strength of the chip package structure and prevent warpage of the substrate 10, to improve package reliability.

Alternatively, after step S80 is performed, S90' is performed. As shown in FIG. 5M, a heat dissipating lid 19 is disposed on the first surface a1 of the substrate 10.

The heat dissipating lid 19 has a groove, and is butted with the substrate 10, or it is understood that the heat dissipating lid 19 is fastened to the substrate 10. The groove and the substrate 10 form an accommodation cavity P, where the accommodation cavity P accommodates the first chip 11, the second chip 12, the first connection chip 13, the conductive columns 14, the first packaging layer 15, the redistribution layer 16, the underfill layer 17, and the ring 18 (or the second packaging layer 18').

The heat dissipating lid 19 may be connected to the substrate 10 by using, for example, a thermally conductive adhesive.

In some embodiments, the thermally conductive adhesive is further disposed between the first chip 11 and the heat dissipating lid 19 and between the second chip 12 and the heat dissipating lid 19, to improve heat dissipation effects of the first chip 11 and the second chip 12.

Certainly, as shown in FIG. 5M, when the heat dissipating lid 19 is disposed on the first surface a1 of the substrate 10, step S90 may be skipped, that is, the step of forming the ring 18 on the substrate 10 is skipped.

Alternatively, after step S80 is performed, S90" is performed. As shown in FIG. 5N, a third packaging layer 19' is disposed on the first surface a1 of the substrate 10.

The third packaging layer 19' wraps at least the side surface of the first chip 11, the side surface of the second chip 12, and the first packaging layer 15. For example, the third packaging layer 19' wraps the first packaging layer 15, the second packaging layer 18', the first chip 11, and the second chip 12. Certainly, the third packaging layer 19' may leave exposed the second packaging layer 18', and surfaces that are of the first chip 11 and the second chip 12 and that are away from the substrate 10.

A material of the third packaging layer 19' may be the same as the material of the first packaging layer 15.

It should be noted that, in a packaging process, one or more of the steps S90, S90', and S90" may be performed. For ease of description, an example in which the ring 18 is disposed on the substrate 10 is only used below for description.

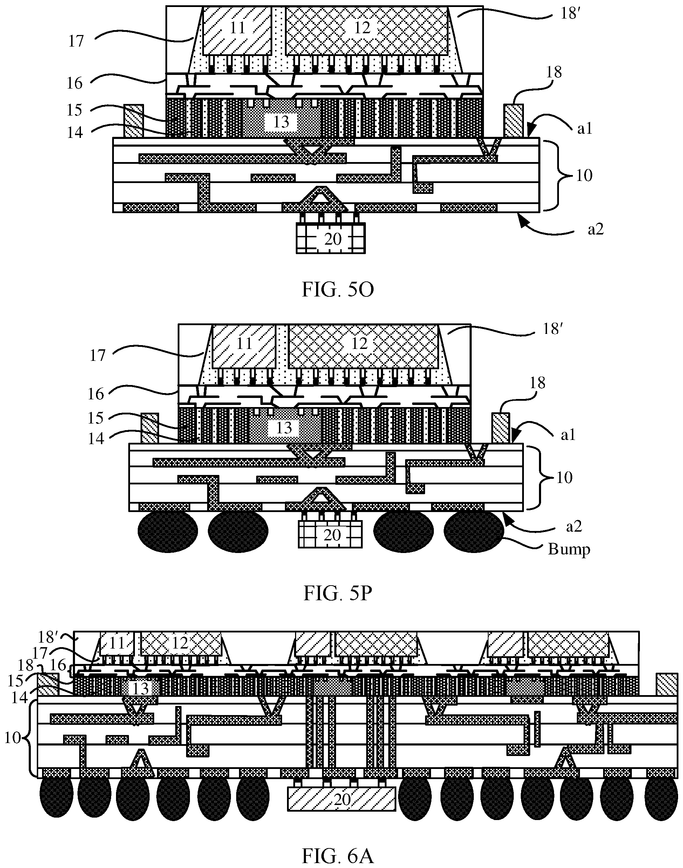

S100: As shown in FIG. 5O, dispose a fourth chip 20 on a second surface a2 of the substrate 10.

The fourth chip 20 is coupled to the substrate 10. In some embodiments, an active surface of the fourth chip 20 faces the second surface a2 of the substrate 10.

The fourth chip 20 is not specifically limited, and may be any chip in the electronic device.

S110: As shown in FIG. 5P, dispose bumps on the second surface a2 of the substrate 10.

The bump is located on a periphery of the fourth chip 20, and a material of the bump may be, for example, copper/tin or copper/tin/silver.

It should be noted that there is no limitation whatsoever on a sequence of steps in the foregoing packaging method provided in this embodiment of this application, and the sequence may be reasonably adjusted as required.

In addition, some of the steps S10 to S 110 may be removed based on a requirement, and there is no limitation that each step needs to be included. Some extra steps may also be added as required, that is, the foregoing packaging method is not limited to the foregoing steps.

In addition, FIG. 5A to FIG. 5P merely show a case in which the chip package structure includes one first connection chip 13 and one pair of the first chip 11 and the second chip 12.

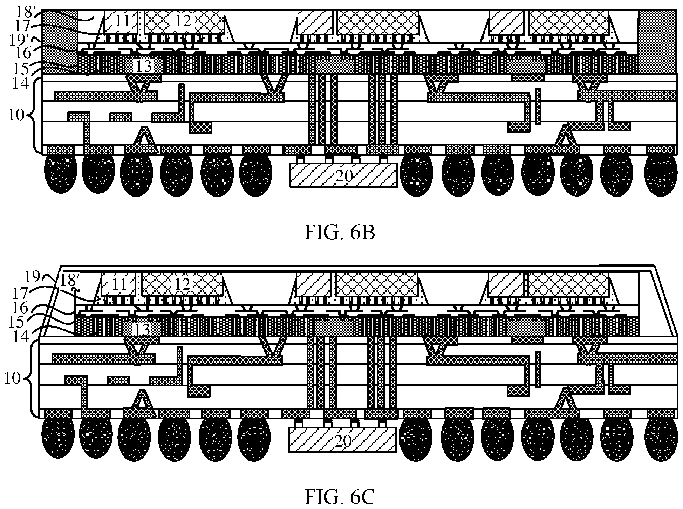

As shown in FIG. 6A, FIG. 6B, and FIG. 6C, the chip package structure may further include a plurality of first connection chips 13 and a plurality of pairs of the first chip 11 and the second chip 12.

That is, the chip package structure in this embodiment of this application includes at least one first chip 11 and at least one second chip 12. In some embodiments, a quantity of first chips 11 may be the same as a quantity of second chips 12.

One first chip 11 and one second chip 12 form a pair, and the first chip 11 and the second chip 12 in the same pair are coupled to a same first connection chip 13.

In a case in which the chip package structure includes a plurality of first connection chips 13 and a plurality of pairs of the first chip 11 and the second chip 12, functions of the first chips 11 (for example, a first chip 11a and a first chip 11b that belong to different pairs) in different pairs may be the same, or may be different. Functions of the second chips 12 (for example, a second chip 12a and a second chip 12b that belong to different pairs) in different pairs may be the same, or may be different. Functions of the first chip 11 and the second chip 12 (for example, the first chip 11a and the second chip 12b that belong to different pairs) in different pairs may be the same, or may be different.

For example, the plurality of the first chips 11 are all the foregoing HBMs, and the plurality of the second chips 12 are all the foregoing processor chips.

FIG. 6A shows an example in which the chip package structure includes the ring 18. FIG. 6B shows an example in which the chip package structure includes the third packaging layer 19'. FIG. 6C shows an example in which the chip package structure includes the heat dissipating lid 19.

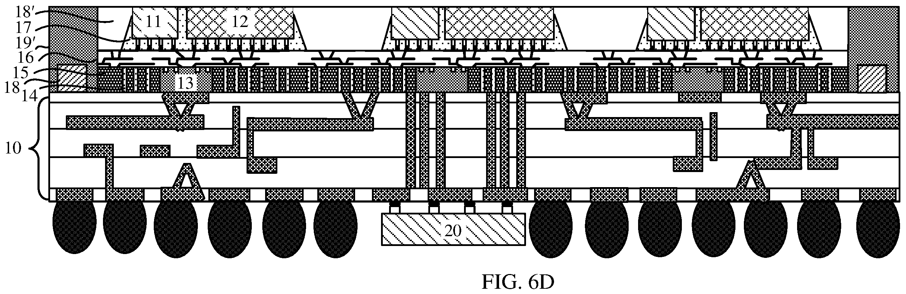

Certainly, as shown in FIG. 6D, the chip package structure may further include the ring 18 and the third packaging layer 19', or include the heat dissipating lid 19 and the third packaging layer 19'.

In this embodiment of this application, the conductive columns 14 are directly grown on the first surface a1 of the substrate 10, so that the conductive columns 14 are directly coupled to the first substrate 10. This obviates the need to transfer and bond the conductive columns 14 onto the substrate 10, making process steps simple. In addition, the conductive columns 14 and the substrate 10 do not need to be bonded by using a solder, thereby avoiding a signal conduction problem caused by poor bonding. The absence of a bonding interface between the conductive columns 14 and the substrate 10 ensures a better signal conduction effect and a more stable structure.

In addition, the first connection chip 13 and a second connection chip 22 are chips. Compared with a manner in which cabling is performed on the substrate 10, integration of the first connection chip 13 and the second connection chip 22 is higher. This means an obtained chip package structure is more highly integrated, and is therefore applicable to an ultra-high-density and high-performance computing (high-performance computing, HPC) package.

In addition, in this embodiment of this application, the packaged first chip 11 and the packaged second chip 12 are separately coupled to the conductive columns 14 and the first connection chip 13 by using a process such as TCB or MR, instead of being packaged together in advance. The first chip 11 and the second chip 12 are interconnected through the first connection chip 13 to implement packaging, and the packaging is similar to multi-chip module (multi-chip module, MCM) packaging in appearance. Therefore, compared with bonding between a large-area multi-die packaging structure and the substrate 10, bonding between a single chip and the substrate 10 can reduce process difficulty, improve process implementability, and avoid problems of invalid bonding and incomplete underfilling (an underfill is insufficiently applied), thereby improving a product yield rate. In addition, compared with bonding of the large-area multi-die packaging structure, bonding of the single chip can significantly reduce stress and alleviate problems of stress, warpage, and the like caused by a large size of the chip package structure.

In addition, in this embodiment of this application, the first chip 11 and the second chip 12 are separately disposed on the substrate 10, and may be applicable to heterogeneous integration of chiplets (chiplets) in the future. A large chip is split into single dies, to implement multi-die packaging and thereby form a system in package.

### Example 2

A difference between Example 2 and Example 1 lies in that the chip package structure in Example 2 excludes the foregoing redistribution layer 16.

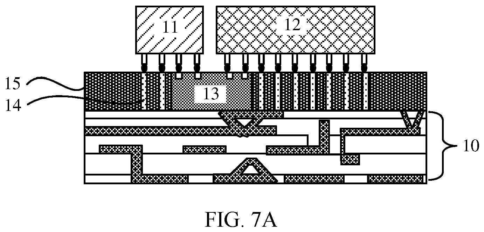

As shown in FIG. 7A, the chip package structure mainly includes a substrate 10, a first chip 11, a second chip 12, a first connection chip 13, a plurality of conductive columns 14, and a first packaging layer 15.

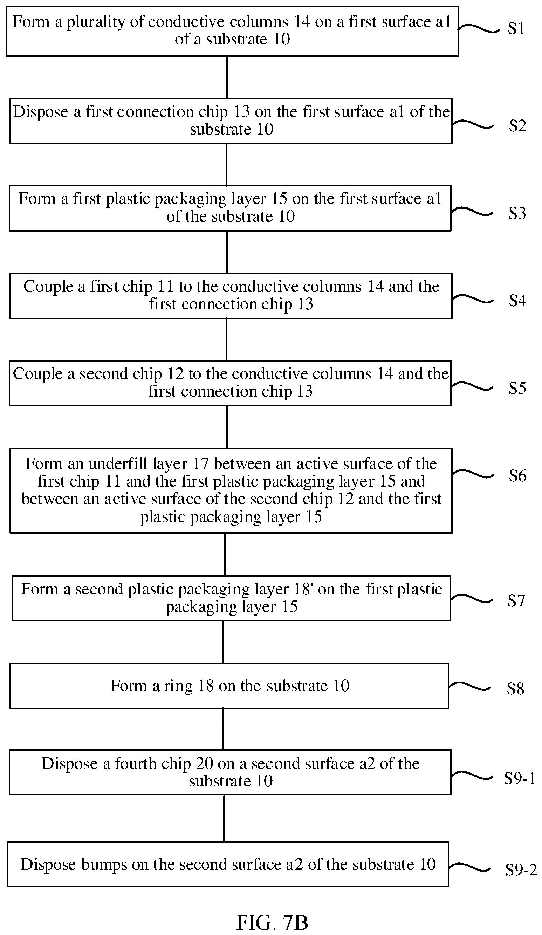

As shown in FIG. 7B, this embodiment of this application provides a packaging method for a chip package structure, including the following steps.

S1: Form the plurality of conductive columns 14 on a first surface a1 of the substrate 10.

Step S1 may be the same as step S10 in Example 1. Refer to the foregoing description.

S2: Dispose the first connection chip 13 on the first surface a1 of the substrate 10.

Step S2 may be the same as step S20 in Example 1. Refer to the foregoing description.

S3: Form the first packaging layer 15 on the first surface a1 of the substrate 10.

Step S3 may be the same as step S30 in Example 1. Refer to the foregoing description.

S4: Couple the first chip 11 to the conductive columns 14 and the first connection chip 13.

For example, the first chip 11 may be coupled to the conductive columns 14 and the first connection chip 13 by using a bonding process or a conductive adhesive, and the coupled first chip 11 is disposed on a side that is of the first packaging layer 15 and that is away from the substrate 10.

S5: Couple the second chip 12 to the conductive columns 14 and the first connection chip 13.

For example, the second chip 12 may be coupled to the conductive columns 14 and the first connection chip 13 by using a bonding process or a conductive adhesive, and the coupled second chip 12 is disposed on the side that is of the first packaging layer 15 and that is away from the substrate 10.

The first chip 11 and the second chip 12 are coupled to different conductive columns 14. In other words, each conductive column 14 can only be coupled to either of the first chip 11 or the second chip 12.

S6: Form an underfill layer 17 between an active surface of the first chip 11 and the first packaging layer 15 and between an active surface of the second chip 12 and the first packaging layer 15.

A manner of forming the underfill layer 17 may be the same as that in Example 1, and details are not described herein again.

S7: Form a second packaging layer 18' on the first packaging layer 15.

The second packaging layer 18' may be disposed on the first surface a1 of the substrate 10, or may be disposed on a surface that is of the first packaging layer 15 and that is away from the substrate 10. For details, refer to related descriptions in Example 1.

S8: Form a ring 18 on the substrate 10.

The ring 18 may be disposed on the first surface a1 of the substrate 10, or may be disposed on the surface that is of the first packaging layer 15 and that is away from the substrate 10. For details, refer to related descriptions in Example 1.

S9-1: Dispose a fourth chip 20 on a second surface a2 of the substrate 10.

Step S9-1 may be the same as step S100 in Example 1. Refer to the foregoing description.

S9-2: Dispose bumps on the second surface a2 of the substrate 10.

Step S9-2 may be the same as step S110 in Example 1. Refer to the foregoing description.

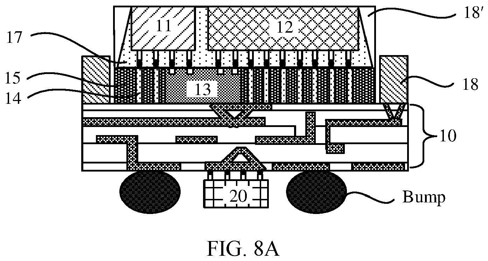

Therefore, the chip package structure obtained by using the foregoing packaging method, as shown in FIG. 8A, may include one first connection chip 13 and one pair of the first chip 11 and the second chip 12.

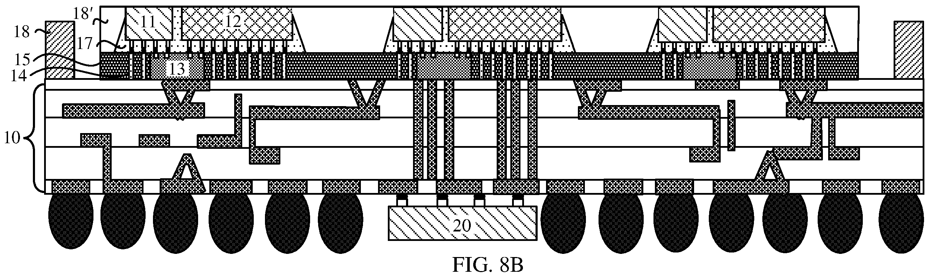

As shown in FIG. 8B, the chip package structure may further include a plurality of first connection chips 13 and a plurality of pairs of the first chip 11 and the second chip 12.

That is, a difference between Example 2 and Example 1 lies in that, in Example 2, the chip package structure excludes the redistribution layer 16, the first chip 11 is directly coupled to the first connection chip 13 and the conductive columns 14, and the second chip 12 is also directly coupled to the first connection chip 13 and the conductive columns 14. In Example 1, both the first chip 11 and the second chip 12 are coupled to the first connection chip 13 and the conductive columns 14 through the redistribution layer 16.

When the redistribution layer 16 is disposed between the conductive columns 14 and the first chip 11 and between the conductive columns 14 and the second chip 12, signal pins on the substrate 10 may be re-arranged by the redistribution layer 16. Density of the signal pins on the redistribution layer 16 may be greater than density of the signal pins on the substrate 10, so that pin density of the corresponding first chip 11 and second chip 12 increases, thereby facilitating miniaturization of the first chip 11 and the second chip 12. In this way, line precision and signal density may be improved, thereby implementing high-density interconnection.

### Example 3

A difference between Example 3 and Example 1 lies in that the chip package structure in Example 3 further includes a third chip and a second connection chip.

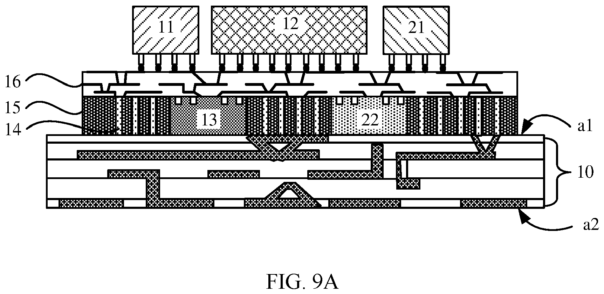

As shown in FIG. 9A, the chip package structure mainly includes a substrate 10, a first chip 11, a second chip 12, a third chip 21, a first connection chip 13, a second connection chip 22, a plurality of conductive columns 14, a first packaging layer 15, and a redistribution layer 16.

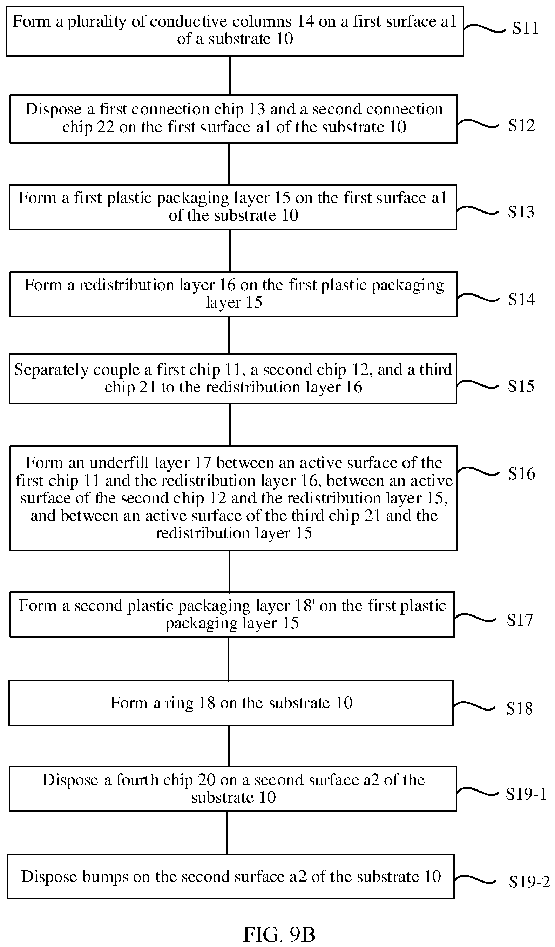

As shown in FIG. 9B, this embodiment of this application provides a packaging method for a chip package structure, including the following steps.

S11: Form the plurality of conductive columns 14 on a first surface a1 of the substrate 10.

Step S1 may be the same as step S10 in Example 1. Refer to the foregoing description. It should be noted that not only a to-be-disposed first connection chip area Q is reserved on the substrate 10, but also a to-be-disposed second connection chip area is reserved on the substrate 10. The conductive columns 14 are disposed on a periphery of the to-be-disposed first connection chip area Q and a periphery of the to-be-disposed second connection chip area.

S12: Dispose the first connection chip 13 and the second connection chip 22 on the first surface a1 of the substrate 10.

A manner of disposing the first connection chip 13 and the second connection chip 22 may be the same as the manner of disposing the first connection chip 13 in step S12 in Example 1. A main difference lies in that in this example, not only the first connection chip 13 is disposed, but also the second connection chip 22 is disposed. The second connection chip 22 is connected to the substrate 10, with a back surface of the second connection chip 22 facing the substrate 10, that is, an active surface of the second connection chip 22 away from the substrate 10.

The first connection chip 13 and the second connection chip 22 may be synchronously disposed on the first surface a1 of the substrate 10, or may be successively disposed on the first surface a1 of the substrate 10.

When the chip package structure includes a plurality of first connection chips 13 and a plurality of second connection chips 22, the plurality of first connection chips 13 may be synchronously disposed on the first surface a1 of the substrate 10, or may be successively disposed on the first surface a1 of the substrate 10; and the plurality of second connection chips 22 may be synchronously disposed on the first surface a1 of the substrate 10, or may be successively disposed on the first surface a1 of the substrate 10.

S13: Form the first packaging layer 15 on the first surface a1 of the substrate 10.

S14: Form the redistribution layer 16 on the first packaging layer 15.

The redistribution layer 16 is separately coupled to the first connection chip 13, the conductive columns 14, and the second connection chip 22.

S15: Separately couple the first chip 11, the second chip 12, and the third chip 21 to the redistribution layer 16.

A sequence in which the first chip 11, the second chip 12, and the third chip 21 are coupled to the redistribution layer 16 is not limited, and may be synchronously coupled or may be sequentially coupled.

In this embodiment of this application, the first chip 11 and the third chip 21 may be the same or may be different. For example, both the first chip 11 and the third chip 21 are the foregoing SOCs, and the second chip 12 is the foregoing HBM.

For a relationship among the first chip 11, the second chip 12, and the third chip 21, refer to the description of a relationship between the first chip 11 and the second chip 12 in Example 1. Details are not described herein again.

S16: Form an underfill layer 17 between an active surface of the first chip 11 and the redistribution layer 16, between an active surface of the second chip 12 and the redistribution layer 16, and between an active surface of the third chip 21 and the redistribution layer 16.

S17: Form a second packaging layer 18' on the first packaging layer 15.

S18: Form a ring 18 on the substrate 10.

S19-1: Dispose a fourth chip 20 on a second surface a2 of the substrate 10.

S19-2: Dispose bumps on the second surface a2 of the substrate 10.

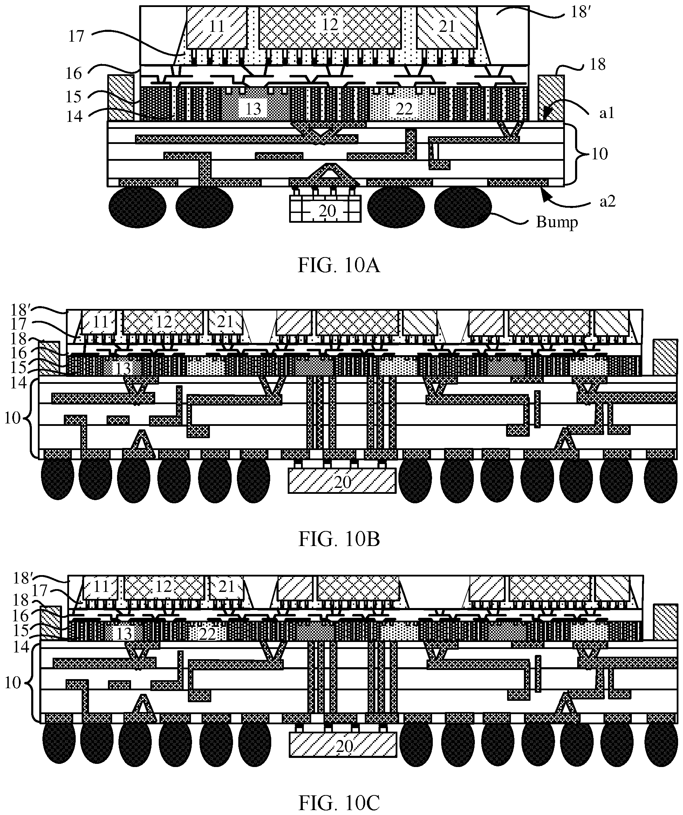

The chip package structure obtained by using the foregoing packaging method is shown in FIG. 10A and FIG. 10B. The first chip 11, the second chip 12, the third chip 21, the first connection chip 13, and the second connection chip 22 are used as a first repetition unit.

As shown in FIG. 10A, the chip package structure may include one first repetition unit. As shown in FIG. 10B, the chip package structure may include a plurality of first repetition units. Certainly, as shown in FIG. 10C, the chip package structure may include not only at least one first repetition unit, but also at least one second repetition unit consisting of the first chip 11, the second chip 12, and the first connection chip 13.

It can be learned from the description of this example that one second chip 12 may be coupled to a plurality of chips (for example, the first chip 11 and the third chip 21) by using a connection chip. Therefore, FIG. 10A and FIG. 10B show that the second chip 12 is coupled to the first chip 11 by using the first connection chip 13, and the second chip 12 is further coupled to the third chip 21 by using the second connection chip 22.

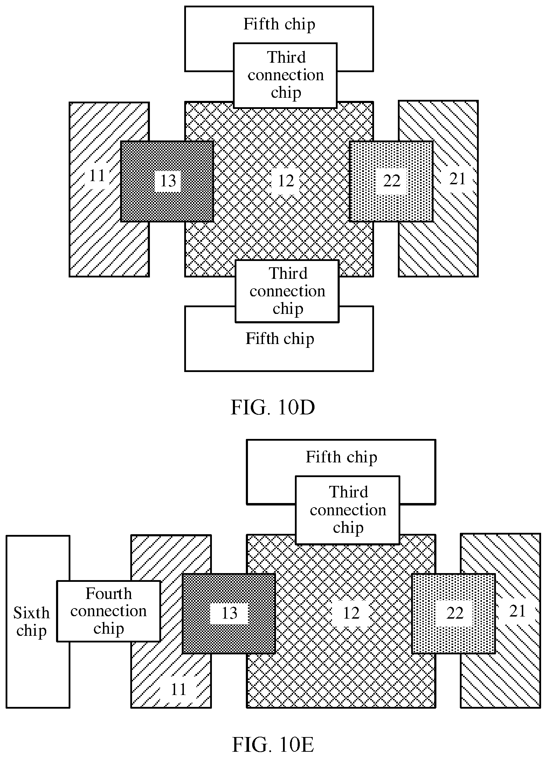

However, the chip package structure in this embodiment of this application is not limited thereto. Based on the structures shown in FIG. 10A and FIG. 10B, for example, as shown in FIG. 10D, the second chip 12 may be further coupled to a fifth chip by using a third connection chip. Alternatively, for example, as shown in FIG. 10E, the first chip 11 may be coupled to a sixth chip by using a fourth connection chip. This is not limited in this embodiment of this application. In other words, in the chip package structure provided in this embodiment of this application, each chip located on a side that is of the first packaging layer 15 and that is away from the substrate 10 may be coupled to at least one other chip by using a connection chip. The structure is flexible and widely applicable.

### Example 4

A difference between Example 4 and Example 3 lies in that the chip package structure in Example 4 excludes the redistribution layer 16.

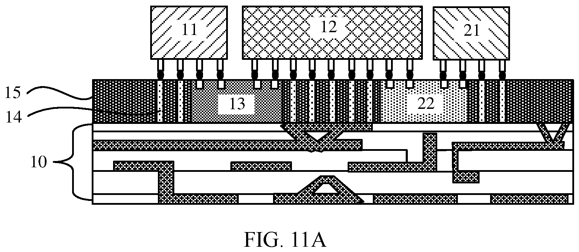

As shown in FIG. 11A, the chip package structure mainly includes a substrate 10, a first chip 11, a second chip 12, a third chip 21, a first connection chip 13, a second connection chip 22, a plurality of conductive columns 14, and a first packaging layer 15.

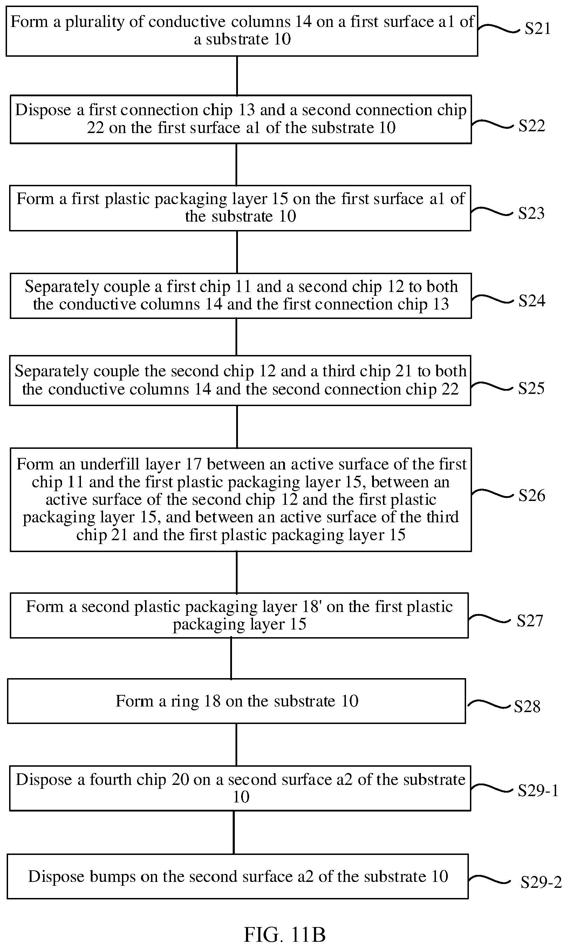

As shown in FIG. 11B, this embodiment of this application provides a packaging method for a chip package structure, including the following steps.

S21: Form the plurality of conductive columns 14 on a first surface a1 of the substrate 10.

S22: Dispose the first connection chip 13 and the second connection chip 22 on the first surface a1 of the substrate 10.

S23: Form the first packaging layer 15 on the first surface a1 of the substrate 10.

S24: Separately couple the first chip 11 and the second chip 12 to both the conductive columns 14 and the first connection chip 13.

S25: Separately couple the second chip 12 and the third chip 21 to both the conductive columns 14 and the second connection chip 22.

The first chip 11, the second chip 12, and the third chip 21 are coupled to different conductive columns 14. In other words, each conductive column 14 can only be coupled to one of the first chip 11, the second chip 12, and the third chip 21.

In addition, step S24 and step S25 may be performed separately without a limitation on a sequence, or may be performed synchronously.

S26: Form an underfill layer 17 between an active surface of the first chip 11 and the first packaging layer 15, between an active surface of the second chip 12 and the first packaging layer 15, and between an active surface of the third chip 21 and the first packaging layer 15.

S27: Form a second packaging layer 18' on the first packaging layer 15.

S28: Form a ring 18 on the substrate 10.

S29-1: Dispose a fourth chip 20 on a second surface a2 of the substrate 10.

S29-2: Dispose bumps on the second surface a2 of the substrate 10.

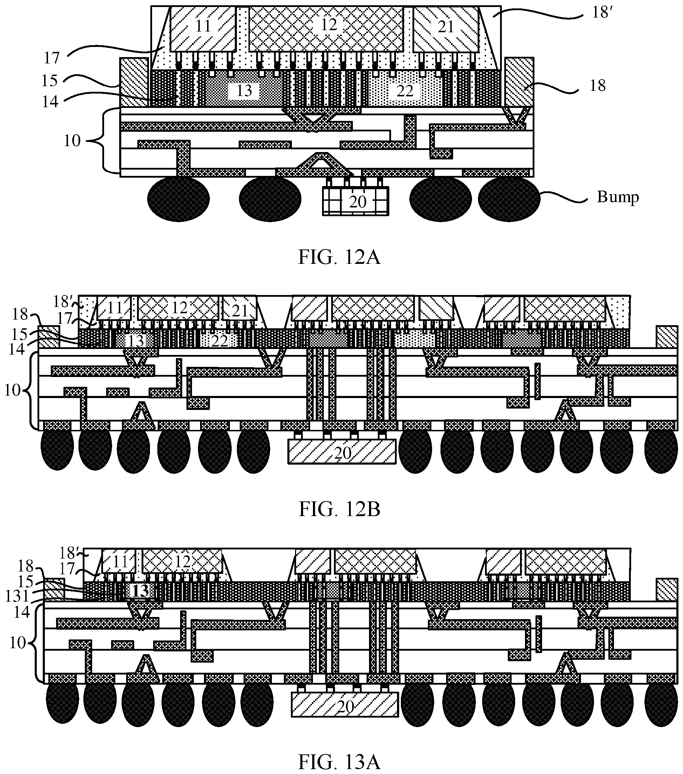

The chip package structure obtained by using the foregoing packaging method is shown in FIG. 12A and FIG. 12B. The first chip 11, the second chip 12, the third chip 21, the first connection chip 13, and the second connection chip 22 are used as a first repetition unit. As shown in FIG. 12A, the chip package structure may include at least one first repetition unit. As shown in FIG. 12B, the chip package structure may include not only the at least one first repetition unit, but also at least one second repetition unit consisting of the first chip 11, the second chip 12, and the first connection chip 13.

### Example 5

A difference between Example 5 and Example 1 to Example 4 lies in that the first connection chip 13 in Example 5 includes vias, where the vias penetrate a back surface of the first connection chip 13 and are coupled to the substrate 10. In other words, in Example 1 to Example 4, the back surface of the first connection chip 13 is fixedly connected to the substrate 10, and in Example 5, the back surface of the first connection chip 13 is coupled to the substrate 10.

A method for preparing the chip package structure provided in this example is basically the same as that in Example 1 to Example 4, and a difference mainly lies in the following:

In Example 1 to Example 4, in the foregoing steps S20, S2, S12, and S22, disposing the first connection chip 13 on the first surface a1 of the substrate 10 is adhering the back surface of the first connection chip 13 to the substrate 10.

In this example, disposing the first connection chip 13 on the first surface a1 of the substrate 10 is coupling the vias on the first connection chip 13 to the substrate 10.

For example, the vias on the first connection chip 13 are coupled to the substrate 10 in a manner of fusion bonding (fusion bonding) or a manner of adhesive bonding (adhesive bonding).

For example, a C4 bump (for example, a metal solder such as a bump or a copper column) is disposed on the first surface a1 of the substrate 10, the first connection chip 13 is welded to the substrate 10 by using a welding process, and then an underfill is applied between the back surface of the first connection chip 13 and a first packaging layer 15 by using a thermal compression non-conductive film (thermal compression non-conductive film, TCNCF) process, packagingto stabilize the structure.

Alternatively, the first connection chip 13 adheres to the substrate 10 by using a conductive adhesive.

In a case in which the chip package structure further includes a second connection chip 22, the second connection chip 22 may have a same structure as the second connection chip 22 in Example 1 to Example 4, and a manner of disposing the second connection chip 22 on the substrate 10 is also the same as that in Example 1 to Example 4. The second connection chip 22 may alternatively have a same structure as the first connection chip 13 in this example, that is, the second connection chip 22 also includes vias. Disposing the second connection chip 22 on the substrate 10 is coupling the vias on the second connection chip 22 to the substrate 10.

Therefore, the chip package structure provided in this example, as shown in FIG. 13A, includes the substrate 10, a first chip 11, a second chip 12, the first connection chip 13, a plurality of conductive columns 14, and the first packaging layer 15.

The first connection chip 13 includes vias 131. The vias 131 penetrate the back surface of the first connection chip 13. The first connection chip 13 is disposed on the first surface a1 of the substrate 10, an active surface b of the first connection chip 13 is away from the substrate 10, and the vias 131 in the first connection chip 13 are coupled to the substrate 10.

The plurality of conductive columns 14 are disposed on the first surface a1 of the substrate 10, and are located on a periphery of the first connection chip 13. The conductive columns 14 are directly coupled to the substrate 10.

The first packaging layer 15 is disposed on the first surface a1 of the substrate 10 and wraps a side surface of the first connection chip 13 and side surfaces of the conductive column 14, with the active surface b of the first connection chip 13 and top surfaces c of the conductive columns 14 exposed.

The first chip 11 is disposed on a side that is of the first packaging layer 15 and that is away from the substrate 10, and coupled to both the conductive columns 14 and the first connection chip 13.

The second chip 12 is disposed on the side that is of the first packaging layer 15 and that is away from the substrate 10, and coupled to both the conductive columns 14 and the first connection chip 13.

In some embodiments, as shown in FIG. 13A, the chip package structure further includes an underfill layer 17. The underfill layer 17 is disposed between an active surface of the first chip 11 and the first packaging layer 15 and between an active surface of the second chip 12 and the first packaging layer 15.

In some embodiments, as shown in FIG. 13A, the chip package structure further includes a second packaging layer 18'. The second packaging layer 18' is disposed on the first surface a1 of the substrate 10 and wraps at least a side surface of the first chip 11, a side surface of the second chip 12, and the first packaging layer 15.

In some embodiments, as shown in FIG. 13A, the chip package structure further includes a ring 18. The ring 18 is disposed on the first surface a1 of the substrate 10, and is located on a periphery of the first packaging layer 15.

In a case in which the chip package structure further includes the ring 18, for example, the ring 18 is located on a periphery of the second packaging layer 18'.

In some embodiments, as shown in FIG. 13A, the chip package structure further includes a fourth chip 20. The fourth chip 20 is disposed on a second surface a2 of the substrate 10, and is coupled to the substrate 10.

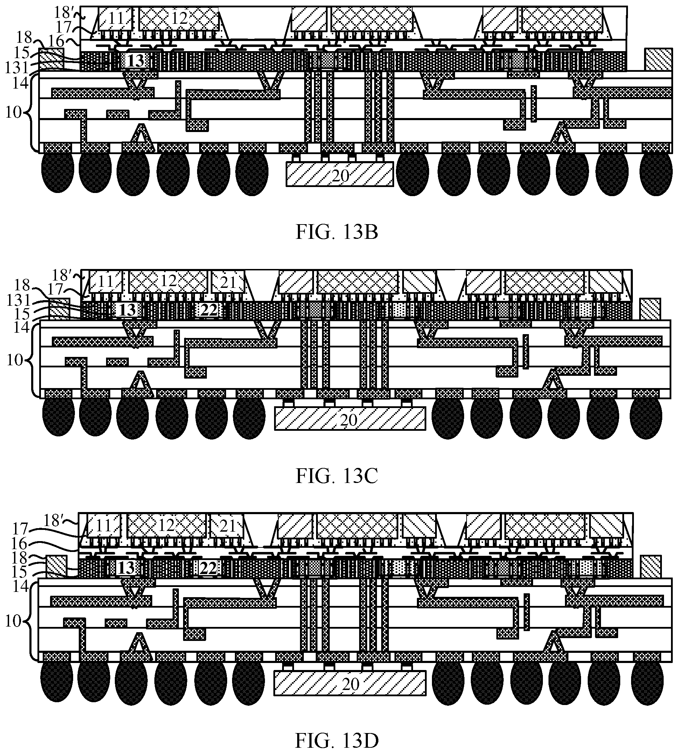

In some embodiments, as shown in FIG. 13B, the chip package structure further includes a redistribution layer 16. The redistribution layer 16 is disposed between the active surface of the first chip 11 and the first packaging layer 15 and between the active surface of the second chip 12 and the first packaging layer 15.

In this case, the first chip 11 and the second chip 12 are separately coupled to both the conductive columns 14 and the first connection chip 13 through the redistribution layer 16.

The underfill layer 17 is disposed between the active surface of the first chip 11 and the redistribution layer 16 and between the active surface of the second chip 12 and the redistribution layer 16.

In addition, the second packaging layer 18' further covers the redistribution layer 16.

In some embodiments, as shown in FIG. 13C and FIG. 13D, the chip package structure further includes the second connection chip 22 and a third chip 21.

The second connection chip 22 is disposed on the first surface a1 of the substrate 10, and an active surface of the second connection chip 22 is away from the substrate 10.

As shown in FIG. 13C, the third chip 21 is disposed on the side that is of the first packaging layer 15 and that is away from the substrate 10, and coupled to both the conductive columns 14 and the second connection chip 22. The second chip 12 is further coupled to the second connection chip 22.

Alternatively, as shown in FIG. 13D, the third chip 21 is disposed on a side that is of the redistribution layer 16 and that is away from the substrate 10, and coupled to the conductive columns 14 and the second connection chip 22 through the redistribution layer 16. The second chip 12 is further coupled to the second connection chip 22 through the redistribution layer 16.

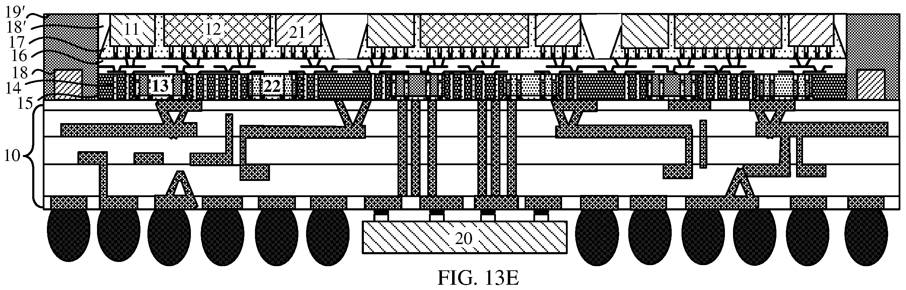

Certainly, as shown in FIG. 13E, the chip package structure may further include the ring 18 and a third packaging layer 19', or include a heat dissipating lid 19 and the third packaging layer 19'. FIG. 13A to FIG. 13D only use the ring 18 as examples for description.

In this embodiment of this application, when the first connection chip 13 and/or the second connection chip 22 are/is selected as chips including vias, and the vias are coupled to the substrate 10, power supply and a signal transmission amount may be increased, and utilization of pins below the first connection chip 13 and the second connection chip 22 may be improved.

In another aspect of this application, a non-transitory computer-readable storage medium used with a computer is further provided. The computer has software for creating and preparing the foregoing chip package structure. The computer-readable storage medium stores one or more computer-readable data structures. The one or more computer-readable data structures have control data, such as photomask data, for preparing the chip package structure provided in any figure provided above.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising:
a substrate;
a first connection chip, disposed on a first surface of the substrate, wherein an active surface of the first connection chip is away from the substrate;
a plurality of conductive columns, disposed on the first surface of the substrate and located on a periphery of the first connection chip, wherein the conductive columns are directly coupled to the substrate;
a first packaging layer, disposed on the first surface of the substrate and wrapping a side surface of the first connection chip and side surfaces of the conductive columns, with the active surface of the first connection chip and top surfaces of the conductive columns exposed;
a first chip, disposed on a side that is of the first packaging layer and that is away from the substrate, and coupled to both the conductive columns and the first connection chip; and
a second chip, disposed on the side that is of the first packaging layer and that is away from the substrate, and coupled to both the conductive columns and the first connection chip.

2. The chip package structure according to claim 1, wherein the chip package structure further comprises a redistribution layer, and the redistribution layer is disposed between the first packaging layer and the first chip; and
the redistribution layer is coupled to the conductive columns and the first connection chip, and the redistribution layer is further coupled to the first chip and the second chip.

3. The chip package structure according to claim 1 or 2, wherein a back surface of the first connection chip is bonded to the substrate.

4. The chip package structure according to claim 1 or 2, wherein the first connection chip comprises vias, and the vias penetrate a back surface of the first connection chip and are coupled to the substrate.

5. The chip package structure according to any one of claims 1 to 4, wherein heights of the plurality of conductive columns are the same in a direction perpendicular to the substrate.

6. The chip package structure according to any one of claims 1 to 5, wherein the chip package structure further comprises a second packaging layer; and
the second packaging layer is disposed on the first packaging layer and wraps at least a side surface of the first chip and a side surface of the second chip.

7. The chip package structure according to any one of claims 1 to 6, wherein the chip package structure further comprises a ring; and
the ring is disposed on the first surface of the substrate and surrounds the first packaging layer.

8. The chip package structure according to any one of claims 1 to 7, wherein the chip package structure further comprises a heat dissipating lid;
the heat dissipating lid has a groove, and is butted with the substrate, and an accommodation cavity is formed between the groove and the substrate; and the first packaging layer, the first chip, and the second chip are located in the accommodation cavity.

9. The chip package structure according to any one of claims 1 to 8, wherein the chip package structure further comprises a third packaging layer, and the third packaging layer is disposed on the first surface of the substrate and wraps at least the side surface of the first chip, the side surface of the second chip, and the first packaging layer.

10. The chip package structure according to any one of claims 1 to 9, wherein the chip package structure further comprises a second connection chip and a third chip;
the second connection chip is disposed on the first surface of the substrate, and an active surface of the second connection chip is away from the substrate;
the third chip is disposed on the side that is of the first packaging layer and that is away from the substrate, and coupled to both the conductive columns and the second connection chip; and
the second chip is further coupled to the second connection chip.

11. The chip package structure according to any one of claims 1 to 10, wherein the chip package structure further comprises a fourth chip; and
the fourth chip is disposed on a second surface of the substrate, and is coupled to the substrate; and the first surface of the substrate is disposed opposite to the second surface.

12. A packaging method for a chip package structure, comprising:
forming a plurality of conductive columns on a first surface of a substrate, wherein the conductive columns are located on a periphery of a to-be-disposed first connection chip area, and are directly coupled to the substrate;
disposing a first connection chip on the first surface of the substrate, wherein an active surface of the first connection chip is away from the substrate;
forming a first packaging layer on the first surface of the substrate, wherein the first packaging layer wraps a side surface of the first connection chip and side surfaces of the conductive column, with the active surface of the first connection chip and top surfaces of the conductive columns exposed;
coupling a first chip to the conductive columns and the first connection chip; and
coupling a second chip to the conductive columns and the first connection chip.

13. The packaging method for a chip package structure according to claim 12, wherein before the coupling a first chip to the conductive columns and the first connection chip, the packaging method further comprises:
forming a redistribution layer on the first packaging layer, wherein the redistribution layer is coupled to the conductive columns and the first connection chip.

14. The packaging method for a chip package structure according to claim 12 or 13, wherein the disposing a first connection chip on the first surface of the substrate comprises:
bonding a back surface of the first connection chip to the substrate.

15. The packaging method for a chip package structure according to claim 12 or 13, wherein the first connection chip comprises vias that penetrate a back surface of the first connection chip, and the disposing a first connection chip on the first surface of the substrate comprises:
coupling a back surface of the first connection chip to the substrate.

16. The packaging method for a chip package structure according to any one of claims 12 to 15, wherein the forming a plurality of conductive columns on a first surface of a substrate comprises:
forming the plurality of conductive columns on the first surface of the substrate by using an electroplating process or a through molding via technology.

17. An electronic device, comprising the chip package structure according to any one of claims 1 to 11, and further comprising a printed circuit board, wherein the chip package structure is disposed on the printed circuit board, and the chip package structure is coupled to the printed circuit board through a substrate.
